# EUROPEAN PATENT APPLICATION

(11) **EP 4 801 224 A1**
(43) Date of publication of application: **02.09.2026**
(21) Application number: 25195027.5
(22) Date of filing: 11.08.2025
(51) Int. Cl.: H10D 86/00, H10D 89/10

(54) **INTEGRATED CIRCUIT (IC) DESIGN SYSTEM AND IC STRUCTURE INCLUDING A FUNCTIONAL BLOCK AND ADJACENT ANCILLARY COMPONENTS**

(30) Priority: 26.02.2025 US 202519063463
(71) Applicant: GlobalFoundries U.S. Inc., Malta, NY 12020 (US)
(72) Inventor: Block, Stefan G., 81541 Munich (DE); Jain, Navneet, Santa Clara, CA 95054 (US); Kim, Juhan, Santa Clara, CA 95054 (US)
(74) Representative: Grünecker Patent- und Rechtsanwälte PartG mbB

(57) **Abstract**

A system for developing a design in an advanced semiconductor-on-insulator processing technology includes a process design kit (PDK). A cell library in the PDK includes compact ancillary component cells placeable adjacent a functional block in a design layout. Some cells contain pairs of ancillary components including: a first ancillary component (e.g., a substrate diode) in a first hybrid area; a second ancillary component (e.g., a zero bias tap, a bias tap, or a signal antenna) in a second hybrid area; a first semiconductor-on-insulator area between the first and second hybrid areas and including less than five gate structures; and a second semiconductor-on-insulator area between the second hybrid area and functional block. Another cell contains a stand-alone signal antenna component and is placeable in the design layout between sections of a stacked memory-type functional block without requiring supporting cells. An IC structure can be manufactured according to such a design layout.

## Description

### BACKGROUND

The present disclosure relates to integrated circuits (ICs) and, more particularly, to embodiments of a design system for developing an IC design layout and embodiments of IC structure manufactured according to such an IC design layout and including a functional block and ancillary components adjacent thereto.

Factors considered in modern integrated circuit design include, but are not limited to, performance improvement, power consumption, and size scaling. Oftentimes design changes with respect to one of these factors can result in an undesirable trade-off with respect to one or more of the other factors. For example, recently IC designs have been developed using advanced semiconductor-on-insulator processing technologies (e.g., fully-depleted silicon-on-insulator (FDSOI) or partially-depleted silicon-on-insulator (PDSOI) processing technologies). These IC designs include semiconductor-on-insulator areas, which include semiconductor and insulator layers stacked on a semiconductor substrate, and hybrid areas (also referred to herein as bulk areas), which are devoid of the semiconductor and insulator layers. Advantages of these IC designs include, for example, optional back gate biasing to improve device performance and device size scaling. However, when such an IC design includes a functional block, design rules may require specific types of ancillary component cells to be placed within the IC design layout adjacent to the functional block in order to ensure that the IC design meets design rule checking (DRC). These ancillary component cells can include, but are not limited to: edge cells (e.g., including a substrate diode); zero bias tap cells (e.g., including contact regions for connecting P-type and N-type well regions below semiconductor-on-insulator areas to ground); bias tap cells (e.g., including contact regions to facilitate application of bias voltages to P-type and N-type well regions below semiconductor-on-insulator areas); and signal antenna cells. Unfortunately, due to the layouts for these ancillary component cells and design rules associated with cell placement, chip area consumption can be significant.

### SUMMARY

Disclosed herein are embodiments of a design system for developing a compact integrated circuit design layout in an advanced semiconductor-on-insulator processing technology. Specifically, the disclosed design system embodiments can include a processor and a storage medium readable by the processor. The storage medium can store an electronic design automation tool and a cell library. The cell library can include cells, which are selectable for inclusion in an integrated circuit design layout. The cells can include ancillary component cells for functional blocks. At least some of the ancillary component cells can be placeable within the layout adjacent at least one side of a functional block on a semiconductor substrate and can include pairs of ancillary components. Each pair of ancillary components can include: a first ancillary component in a first hybrid area of the semiconductor substrate; a second ancillary component in a second hybrid area of the semiconductor substrate; and a first semiconductor-on-insulator area between the first hybrid area and the second hybrid area and including less than five gate structures.

Also disclosed herein are embodiments an IC structure manufactured according to an IC design layout, which has been developed using the disclosed design system so as to include a functional block and structural features defined by one or more ancillary component cells adjacent to the functional block.

Some embodiments of an IC structure disclosed herein can include a semiconductor substrate with both hybrid areas and silicon-on-insulator areas. The IC structure can further include a functional block on the semiconductor substrate and pairs of ancillary components, which are for the functional block and which are positioned laterally adjacent to at least one side of the functional block. Each pair of ancillary components can include: a first ancillary component in a first hybrid area; a second ancillary component in a second hybrid area; and a first semiconductor-on-insulator area between the first hybrid area and the second hybrid area and including less than five gate structures.

Other embodiments of an IC structure disclosed herein can include a semiconductor substrate (e.g., a P-type semiconductor substrate) with both hybrid areas and silicon-on-insulator areas. The IC structure can further include a memory, which is on the semiconductor substrate and which has multiple sections. The IC structure can further include ancillary components including, but not limited to, one or more signal antenna component. A signal antenna component can be between two of the multiple sections of the memory. Furthermore, it can be within a hybrid area, which is devoid of well regions, and it can include a substrate diode. The substrate diode can include: an N-type contact region immediately adjacent to the P-type semiconductor substrate and connected to an input pin; and a P-type contact region immediately adjacent to the P-type semiconductor substrate and connected to a ground rail.

It should be noted that all aspects, examples, and features of disclosed embodiments mentioned in the summary above can be combined in any technically possible way. That is, two or more aspects of any of the disclosed embodiments, including those described in this summary section, may be combined to form implementations not specifically described herein. The details of one or more implementations are set forth in the accompanying drawings and the description below. Other features, objects and advantages will be apparent from the description and drawings, and from the claims.

### BRIEF DESCRIPTION OF THE DRAWINGS

The present disclosure will be better understood from the following detailed description with reference to the drawings, which are not necessarily drawn to scale and in which:
FIGs. 1A-1C are plan view drawings illustrating examples of IC structures manufactured according to IC design layouts including ancillary component cells adjacent to a functional block or sections thereof;
FIG. 2 is a schematic diagram illustrating disclosed embodiments of a design system;
FIGs. 3.1A-3.1D are plan view drawings illustrating various embodiments of IC structures manufactured according to IC design layouts developed using the design system of FIG. 2 and including compact ancillary component cells (CACs);
FIG. 3.2 is a perspective drawing illustrating in greater detail portion A of the IC structure shown in FIG. 3.1A;
FIG. 3.3 is a perspective drawing illustrating in greater detail portion B of the IC structure shown in FIG. 3.1B;
FIG. 3.4 is a perspective drawing illustrating in greater detail portion C of the IC structure shown in FIG. 3.1C;
FIG. 3.5 is a perspective drawing illustrating in greater detail portion D of the IC structure shown in FIG. 3.1D; and
FIG. 4 is a schematic diagram illustrating an example hardware environment for implementing aspects of the disclosed system, method, and computer program product embodiments.

### DETAILED DESCRIPTION

As mentioned above, advantages of designing ICs using advanced semiconductor-on-insulator processing technologies include, for example, optional back gate biasing to improve device performance and device size scaling. However, when such an IC design includes a functional block, design rules may require specific types of ancillary component cells to be placed within the IC design layout adjacent to the functional block in order to ensure that the IC design meets design rule checking (DRC). These ancillary component cells can include, but are not limited to: edge cells (e.g., including a substrate diode); zero bias tap cells (e.g., including contact regions for connecting P-type and N-type well regions below semiconductor-on-insulator areas to ground); bias tap cells (e.g., including contact regions to facilitate application of bias voltages to P-type and N-type well regions below semiconductor-on-insulator areas); and signal antenna cells. Unfortunately, due to the layouts for these ancillary component cells and design rules associated with cell placement, chip area consumption can be significant.

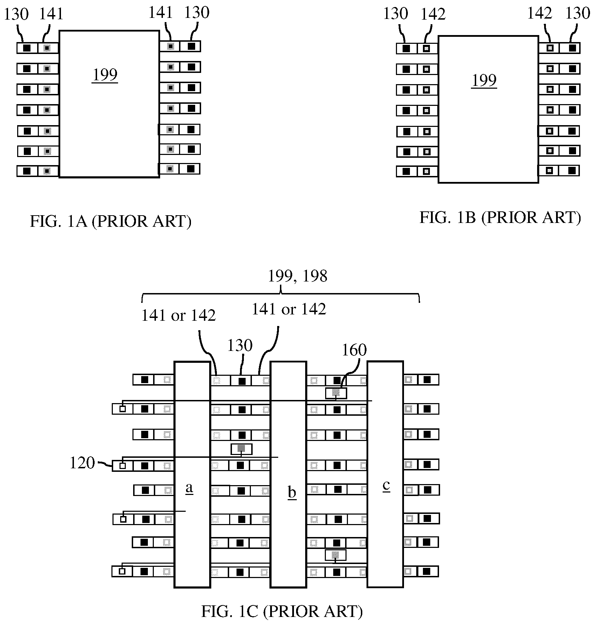

For example, referring to FIGs. 1A and 1B, design rules for an IC design layout in an advanced semiconductor-on-insulator processing technology may require placement of edge cells 130 and tap cells (e.g., either zero bias tap cells 141, as shown in FIG. 1A, or bias tap cells 142, as shown in FIG. 1B) adjacent to a functional block 199. The edge cell 130 can include a hybrid area of a P-type semiconductor substrate. This hybrid area can be devoid of any well regions and can include substrate diode. This substrate diode can include N-type contact region and a P-type contact region adjacent to the P-type semiconductor substrate. The N-type contact region can be connected to a positive supply voltage (VDD) rail and the P-type contact region can be connected to a ground (VSS) rail such that the substrate diode is reverse biased. Each tap cell 141, 142 can also include a hybrid area. The hybrid area can include: a buried N-type well region (buried Nwell) in the P-type semiconductor substrate; aa P-type well region (Pwell) and an N-type well region (Nwell) in the P-type semiconductor substrate above the buried Nwell; and Pwell and Nwell contact regions adjacent to the Pwell and Nwell, respectively. In a zero bias tap cell 141, the Pwell and Nwell contact regions can be connected to a ground (VSS) rail. In a bias tap cell 142, the Pwell contact region can be connected to receive a Pwell bias voltage (VPW) and the Nwell contact region can be connected to receive an Nwell bias voltage (VNW).

These edge cells 130 and tap cells 141-142 can also include additional components (not shown) to enable placement at various locations within an IC design layout while still meeting design rule checking (DRC). These additional components can include, for example, semiconductor-on-insulator areas positioned laterally adjacent to the hybrid area and having three or more gate structures (e.g., dummy gate structures, also referred to herein as non-functioning gate structures) thereon and incorporated into dummy field effect transistors (FETs) (also referred to herein as non-functioning transistors). Thus, when two such cells (e.g., an edge cell and a tap cell) are placed end-to-end within the IC design layout, the hybrid areas of each cell will be physically separated by a pair of semiconductor-on-insulator areas (one from each cell) with a combined total of six or more dummy gate structures thereon and incorporated into multiple dummy FETs. As a result, the chip area consumed will be relatively large.

Additionally, referring to FIG. 1C, design rules for advanced semiconductor-on-insulator IC designs that include a functional block 199 and, more specifically, a stacked memory block 198 with multiple sections (e.g., a-c) of memory may require edge and tap cells as well as other ancillary component cells adjacent thereto (e.g., buffer cells 120). For example, design rules may require placement of signal antenna cells 160 between adjacent sections (e.g., a and b, b and c) of memory. Each signal antenna cell 160 can include a hybrid area. This hybrid area can include a buried Nwell in the P-type semiconductor substrate and a Pwell and an Nwell in the P-type semiconductor substrate above the buried Nwell. This hybrid area can further include back-to-back diodes. These diodes can include two N-type contact regions on the Pwell and physically separated from each other. One N-type contact region can be electrically connected to an input pin and the other can be electrically connected to a ground (VSS) rail such that the diodes are reverse and forward biased, respectively. As with edge cells 130 and tap cells 141 or 142 (discussed above), signal antenna cells 160 can also include additional components (e.g., semiconductor-on-insulator areas with three or more non-functioning gate structures thereon adjacent to the hybrid area) to enable placement at various locations within an IC design layout while still meeting DRC. Furthermore, additional design rules require edge and tap cells to be placed (as supporting cells) near the signal antenna cells 160 between the adjacent sections of memory. Thus, with an IC design including a stacked functional block 198, edge 130 and tap cells 141 or 142 are placed along the border (outer edges) of block 198 and also between adjacent sections within block 198, thereby further increasing the overall chip area consumed by the IC.

In view of the foregoing, disclosed herein are embodiments of a design system for developing a compact IC design layout in an advanced semiconductor-on-insulator processing technology. The design system employs a process design kit (PDK), which includes a cell library. The cell library can include, among various cells selectable for placement in an IC design layout, compact ancillary component (CAC) cells for functional blocks. At least some of these CAC cells can include pairs of ancillary components merged into one cell. For example, such CAC cells can include: a first ancillary component (e.g., a substrate diode) in a first hybrid area of a semiconductor substrate; a second ancillary component (e.g., zero bias tap, a bias tap, or a signal antenna) in a second hybrid area of the semiconductor substrate; a first semiconductor-on-insulator area, which is between the first hybrid area and the second hybrid area and includes no more than three gate structures; and a second semiconductor-on-insulator area, which is between the second hybrid area and the functional block. Another CAC cell in the cell library can include a unique signal antenna component, which is selectable for placement between sections of a stacked memory block, and which does not require placement of other cells adjacent thereto, as supporting cells. Also disclosed herein are embodiments of an IC structure manufactured according to an IC design layout, which has been developed using the disclosed design system so as to include a functional block and the structural features defined by one or more CAC cells adjacent to the functional block.

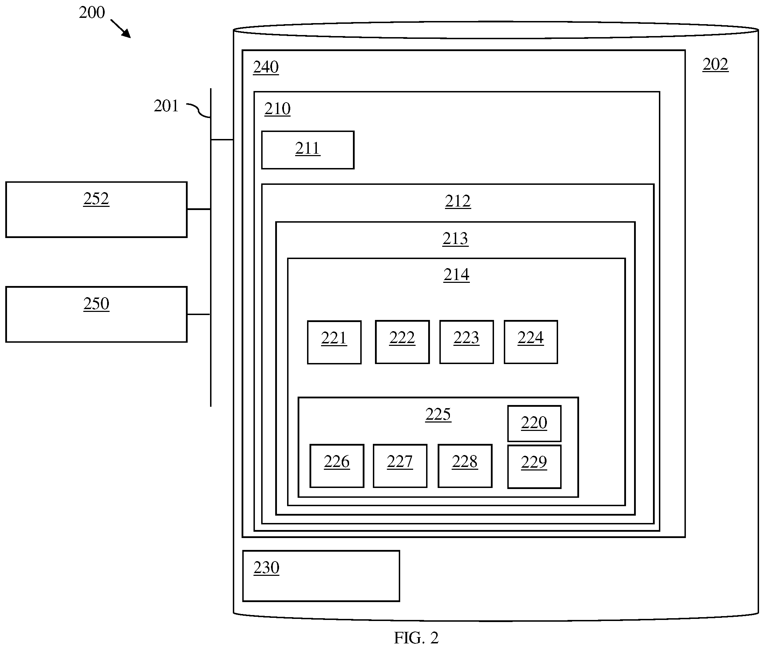

More particularly, FIG. 2 is a schematic diagram illustrating disclosed embodiments of a computer-aided design (CAD) system 200 (hereinafter design system 200). Design system 200 can include multiple system components. These system components can include, but are not limited to, one or more processors 250, one or more display monitors 252, and one or more computer readable storage mediums 202. The system components can be interconnected over a system bus 201 (as illustrated) and/or over a wired or wireless network. For purposes of illustration, design system 200 is described below and illustrated in FIG. 2 as having a single processor and a single storage medium. However, it should be understood that FIG. 2 is not intended to be limiting. Alternatively, design system 200 could incorporate multiple processors for performing one or more of the different processes in a design flow and/or multiple storage mediums, which are accessible by the processor(s) and which store the required data, software tools, etc. for performing the different processes in the design flow. Furthermore, all system components can be co-located. Alternatively, the various system components can be incorporated into a distributed system whose components are located on different networked computers.

Storage medium 202 can store electronic design automation (EDA) tool(s) 230 (e.g., specialized software program(s)). Each EDA tool 230 includes program instructions that are executable by processor 250 to cause processor 250 to perform or assist in the performance of process steps in a computer-aided integrated circuit (IC) design flow. These process steps can include, but are not limited to, establishing design specifications, generating a schematic diagram, simulating performance, generating and editing an IC design layout, design rule checking, etc. Various EDA tools 230 for use in IC design are well known in the art and, thus, the details thereof have been omitted from this specification in order to allow the reader to focus on the salient aspects of the disclosed embodiments.

Storage medium 202 can further store design information 240, which is accessible and usable by one or more EDA tools 230 during performance of the IC design flow. Design information 240 can be, for example, in the form of a process design kit (PDK) 210. A PDK is typically developed by a semiconductor foundry for its customers in order to facilitate design of ICs at a specific processing technology node supported by the foundry. In the disclosed embodiments, PDK 210 can specifically be developed for an advanced semiconductor-on-insulator processing technology (e.g., an FDSOI or PDSOI processing technology).

Those skilled in the art will recognize that advanced semiconductor-on-insulator technologies employ a hybrid semiconductor substrate. This hybrid semiconductor substrate includes a base semiconductor substrate, which is monocrystalline in structure with a first surface (e.g., a bottom surface) and a second surface (e.g., a top surface) opposite the first surface, and which includes both semiconductor-on-insulator areas (e.g., SOI areas) and hybrid areas (also referred to herein bulk semiconductor areas). Each semiconductor-on-insulator area includes an insulator layer on the second surface and a monocrystalline semiconductor layer on the insulator layer. Each hybrid area is devoid of the insulator and monocrystalline semiconductor layer stack and, optionally, includes a monocrystalline epitaxial semiconductor layer (e.g., a monocrystalline silicon layer) immediately adjacent to the second surface of the base semiconductor substrate and electrically isolated from adjacent semiconductor-on-insulator area (e.g., by trench isolation regions). Generally, the semiconductor-on-insulator areas are used as active device regions or provide isolation between hybrid areas, whereas the hybrid areas provide a means for accessing the semiconductor substrate or components therein (e.g., well regions aligned below semiconductor-on-insulator areas).

One advantage of advanced semiconductor-on-insulator processing technologies is that field effect transistors (FETs) can be formed in semiconductor-on-insulator areas aligned above an N-type well region (Nwell) or a P-type well region (Pwell) in order to achieve different types of FETs with different threshold voltages (VTs). For example, for a super low threshold voltage (SLVT) or low threshold voltage (LVT) FET, an N-type field effect transistor (NFET) can be formed above an Nwell and a P-type field effect transistor (PFET) can be formed above a Pwell. For a regular threshold voltage (RVT) or high threshold voltage (HVT) FET, an NFET can be formed above a Pwell and a PFET can be formed above an Nwell. Typically, a functional circuit block will include all SLVT (or LVT) FETs with NFETs above Nwells and PFETs above Pwells or all RVT (or HVT) FETs with NFETs above Pwells and PFETs above Nwells. Whether the FETs are SLVT or LVT FETs or whether they are RVT or HVT FETs will depend upon the design (e.g., device size, etc.) and process specifications (e.g., dopant concentrations, etc.).

Another advantage of advanced semiconductor-on-insulator processing technologies is that, in the semiconductor-on-insulator areas, portions of the insulator layer and well region aligned below each FET effectively form a back gate. Thus, the well region can be electrically connected to receive a bias voltage. For example, the well region can be electrically connected to a ground rail for zero biasing. Alternatively, the well region can be selectively connected to receive a particular bias voltage. This is referred to as back gate biasing or back-biasing and can be employed to fine tune the VT. Specifically, forward back-biasing (FBB) refers to applying a gate bias voltage to the back gate (particularly, to the well region thereof) to reduce the VT of the FET. Reverse back-biasing (RBB) refers specifically to applying a gate bias voltage to the back gate (particularly, to the well region thereof) to increase the VT of the FET, thereby decreasing the switching speed and reducing leakage current. To facilitate back gate biasing, well contact regions (also referred to herein as tap components) can be located in hybrid areas immediately adjacent to the well regions and further electrically connected to receive the desired bias voltage.

In any case, the electronic files within PDK 210 can be accessible by one or more EDA tools 230 executed on design system 200 at different stages in the design flow. Exemplary PDK electronic files include, but are not limited to, simulation models, symbols and technology files for the specific technology node, a cell library 212, and design rule decks (also referred to herein as a design rules database 211).

Cell library 212 can include various different cells 213, which are stored in the cell library 212 and selectable for placement in an IC design layout. Those skilled in the art will recognize that a cell is an abstract representation of an IC component. The IC component can be a single device (e.g., a transistor, capacitor, resistor, etc.), other feature (e.g., an isolation region, etc.), and/or multiple devices or features (e.g., interconnected devices in, for example, a logic gate). Such cells can be standard cells with fixed parameters or parameterized cells (Pcells) with user-selectable parameters. Generally, standard and parameterized cells are well known in the art and, thus, the details thereof have been omitted from this specification (except as they relate to the novel CAC cells disclosed herein and discussed in greater detail below) in order to allow the reader to focus on the salient aspects of the disclosed embodiments.

Cell library 212 can include, among the various cells 213 that are selectable for inclusion in an IC design layout, multiple different types of ancillary component cells 214. Ancillary components refer to components required to support some other IC component in an IC design. One example of an IC component supported by such ancillary component cells 214 includes a functional block. For purposes of this disclosure, a functional block can be, for example, a memory block such as a random access memory (RAM) block (e.g., a static random access memory (SRAM) block, a dynamic random access memory (DRAM) block, etc.), an non-volatile memory (NVM) block), a stacked memory block (e.g., a stacked RAM block, such as a stacked SRAM or RAM block), or any other type of memory block. A functional block can also be an intellectual property (IP) block (e.g., a logic block).

The ancillary component cells 214 can include, for example, conventional ancillary component cells 225 for supporting functional blocks. Such conventional ancillary component cells 225 can include, for example, an edge cell 226, a bias tap cell 227, a zero bias tap cell 228, and a signal antenna cell 229. These cells 226-229 can be configured in essentially the same manner as the edge, zero bias tap, bias tap, and signal antenna cells described above with regard to FIGs. 1.1A-1.1C. Conventional ancillary component cells 225 can also include other types of cells (e.g., buffer cells 220).

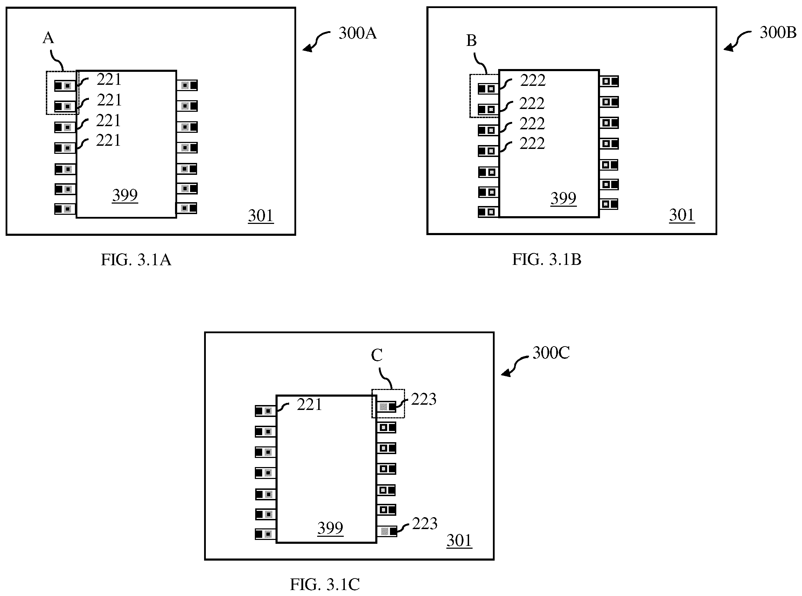

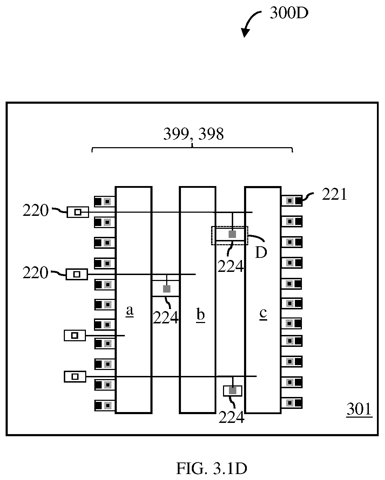

The ancillary component cells 214 can further include several CAC cells 221-224, which are disclosed herein and which facilitate development of an IC design layout that consumes a relatively small amount of chip area. Specific features of these CAC cells 221-224 are illustrated in FIGs. 3.1A-3.1D and further in greater detail in FIGs. 3.2-3.5 and described below. However, generally, CAC cells 221-223, each include a pair of ancillary components (e.g., two different ancillary components as opposed to a single ancillary component). For example, CAC cell 221 includes a pair of ancillary components and, particularly, the ancillary components of both an edge cell and a zero tap cell. CAC cell 222 includes a pair of ancillary components and, particularly, the ancillary components of both an edge cell and a bias tap cell. CAC cell 223 includes a pair of ancillary components of both an edge cell and a signal antenna cell. By including two ancillary components within the same cell, only a single relatively narrow semiconductor-on-insulator area is needed between the ancillary components and that semiconductor-on-insulator area may have, for example, no more than four gate structures (e.g., dummy gate structures, also referred to herein as non-functioning gate structures) thereon and may be devoid of any dummy field effect transistors (FETs) (also referred to herein as non-functioning transistors), as discussed in greater detail below. Thus, the overall length of CAC cell 221 will be significantly less than the combined length of an edge cell 226 and a zero tap cell 227 when placed end-to-end and adjacent a functional block within an IC design layout. The length of CAC cell 222 will be significantly less than the combined length of an edge cell 226 and a bias tap cell 228 when placed end-to-end within an IC design layout. Finally, the length of CAC cell 223 will be significantly less than the combined length of an edge cell 226 and a signal antenna cell 229 when placed end-to-end within an IC design layout.

Another CAC cell 224 disclosed herein can specifically include a unique signal antenna component configured so that supporting cells (e.g., edge and tap cells) are not required to be placed adjacent to it with an IC design layout. Thus, for example, when a functional block of an IC design layout is a stacked memory block (e.g., a stacked RAM block) with multiple sections of memory, only CAC cells 224 (also referred to herein as stand-alone signal antenna cells) need to be placed between adjacent sections of the memory (i.e., the spaces between adjacent sections of the stacked memory can be devoid of other types of ancillary component cells). As a result, spacing between the sections can be reduced and, thus, the area consumed by the stacked memory block can be reduced.

FIGs. 3.1A-3.1D are plan view drawings of IC structures 300A-300D, respectively. Each IC structure 300A-300D can be manufactured according to an IC design layout specifically developed using the disclosed design system and including at least one instance of one or more of CAC cells 221-224 from cell library 212 of PDK 210.

Referring to FIGs. 3.1A-3.1D in combination with FIG. 2, IC structure 300A-300D can be advanced semiconductor-on-insulator structures, as defined above. Each IC structure 300A-300D can include: a semiconductor substrate 301 with both hybrid and semiconductor-on-insulator areas (as discussed in greater below and illustrated in FIGs. 3.2-3.5). Each IC structure 300A-300D can also include a functional block 399 on semiconductor substrate 301 (e.g., in a semiconductor-on-insulator area). Functional block 399 can be, for example, a memory block (e.g., a random access memory (RAM) block, such as a static random access memory (SRAM) block, a dynamic random access memory (DRAM) block, a non-volatile memory block, or any other now known or subsequently developed type of memory block requiring ancillary components cells to be placed adjacent thereto in an IC design layout) or an intellectual property (IP) block (e.g., a logic block).

IC structures 300A-300D can further include ancillary components for functional block 399. These ancillary components can be represented in the IC design layout for the IC structure by any of ancillary component cells 220-229 and, more particularly, by at least one instance of one or more of CAC cells 221-224.

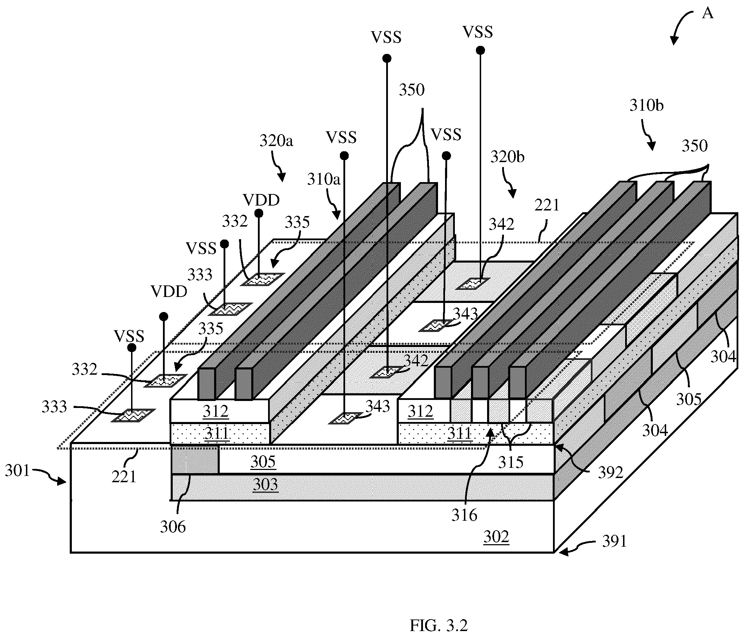

More specifically, IC structure 300A of FIG. 3.1A can include ancillary components represented by multiple instances of CAC cell 221 positioned laterally adjacent to one or more sides of functional block 399. As mentioned above, CAC cell 221 can include a pair of ancillary components and, particularly, the ancillary components of both an edge cell and a zero tap cell. FIG. 3.2 is a perspective drawing illustrating in greater detail portion A of IC structure 300A denoted in FIG. 3.1A and including two CAC cells 221 abutting a functional block.

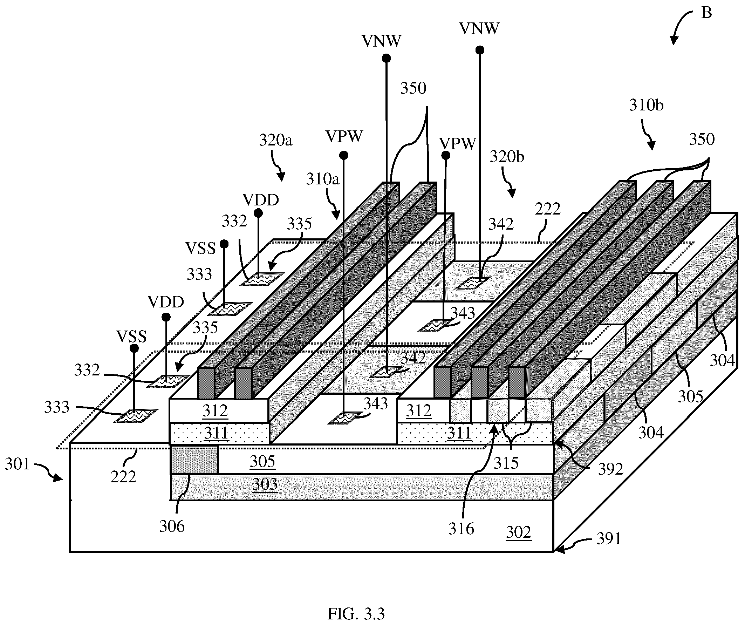

IC structure 300B of FIG. 3.1B can include ancillary components represented by multiple instances of CAC cell 222 positioned laterally adjacent to one or more sides of functional block 399. As mentioned above, CAC cell 222 can include a pair of ancillary components and, particularly, the ancillary components of both an edge cell and a bias tap cell. FIG. 3.3 is a perspective drawing illustrating in greater detail portion B of IC structure 300B denoted in FIG. 3.1B and including to CAC cells 222 abutting a functional block.

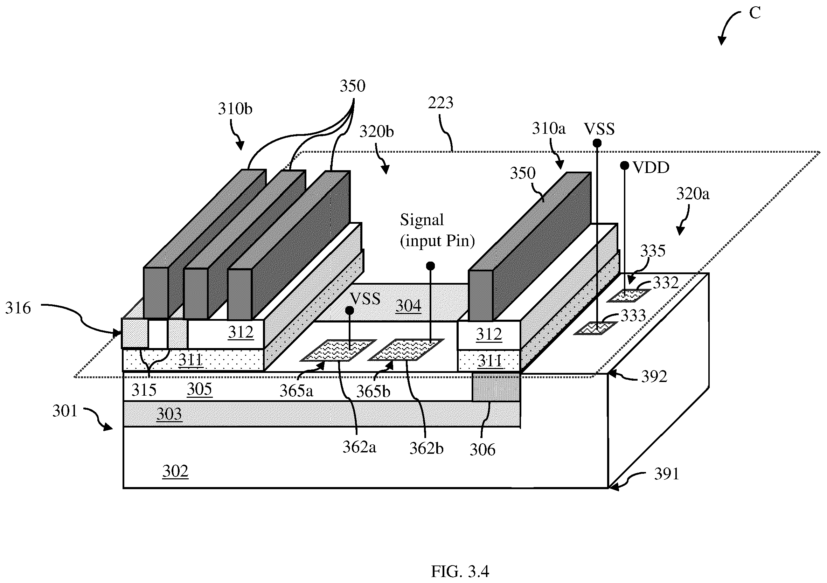

IC structure 300C of FIG. 3.1C can include ancillary components represented by multiple instances of CAC cell 223 positioned laterally adjacent to one or more sides of functional block 399 as well as various other CAC cells (e.g., multiple instances of CAC cell 221, as illustrated, or multiple instances of CAC cell 222, not shown). As mentioned above, CAC cell 223 can include a pair of ancillary components and, particularly, the ancillary components of both an edge cell and a signal antenna cell. FIG. 3.4 is a perspective drawing illustrating in greater detail portion C of IC structure 300C denoted in FIG. 3.1C and including a CAC cell 223 abutting a functional block.

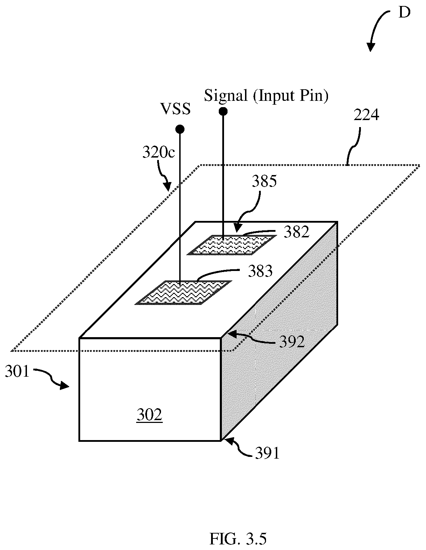

IC structure 300D of FIG. 3.1D can a functional block 399 that is specifically a stacked memory block 398 (e.g., a stacked RAM block). Stacked memory block 398 can include multiple sections of memory. For purpose of illustration, stacked memory block 398 is shown in FIG. 3.1D as including three sections a-c of memory. However, it should be understood that FIG. 31D is not intended to be limiting. Alternatively, stacked memory block 398 could include any number of two or more sections of memory. IC structure 300D can further include ancillary components represented by multiple instances of CAC cell 224 positioned laterally between adjacent sections a-b and b-c. IC structure 300D can also include multiple instances of other ancillary component cells adjacent to one or more sides (e.g., outer boundaries) of functional block 399. These other ancillary component cells can include, for example, multiple instances of CAC cell 221 (as illustrated) or multiple instances of CAC cell 222 (not shown) and multiple instances of buffer cell 220. As mentioned above, CAC cell 224 is a stand-alone signal antenna cell, which doesn't require support cells (edge and/or tap cells) to be placed adjacent thereto between sections a and b or b and c of memory. FIG. 3.5 is a perspective drawing illustrating in greater detail portion D of IC structure 300D denoted in FIG. 3.1D and including CAC cell 224.

Portions A-D of IC structures 300A-300D as illustrated in FIGs. 3.2-3.5, respectively, can each include semiconductor substrate 301 and, particularly, a P-type semiconductor substrate with a first surface 391 (e.g., a bottom surface) and a second surface 392 (e.g., a top surface) opposite the first surface. For example, semiconductor substrate 301 can be a monocrystalline silicon substrate doped so as to have P-type conductivity at a relatively low conductivity level.

Portions A-C of IC structures 300A-300C as illustrated in FIGs. 3.2-3.4, respectively, can each further include: a first hybrid area 320a; a second hybrid area 320b; a first semiconductor-on-insulator area 310a positioned laterally between and abutting the first and second hybrid areas 320a-320b; and a second semiconductor-on-insulator area 310b positioned laterally between and abutting second hybrid area 310b and functional block 399. Each semiconductor-on-insulator area 310a-310b can include an insulator layer 311 (e.g., a silicon diode layer, also referred to herein as a buried oxide layer, or some other suitable insulator layer) on second surface 392 and a monocrystalline semiconductor layer 312 (e.g., a silicon layer or other suitable monocrystalline semiconductor layer) on the insulator layer 311. Each hybrid area 320a-320b is devoid of the insulator layer 311 and monocrystalline semiconductor layer 312. Optionally, each hybrid area 320a-320b includes a monocrystalline epitaxial semiconductor layer (e.g., a monocrystalline silicon layer) immediately adjacent to second surface 392 and electrically isolated from adjacent semiconductor-on-insulator areas (e.g., by trench isolation regions). To avoid clutter in the figures and allow the reader to focus on the salient aspects disclosed embodiments, epitaxial semiconductor layers on the semiconductor substrate in the hybrid areas and trench isolation regions have been omitted from the figures.

Within first hybrid area 320a, semiconductor substrate 301 can be devoid of any well regions. That is, within first hybrid area 320a, semiconductor substrate 301 can be doped only so as to have P-type conductivity at a relatively low conductivity level (e.g., so as to have P-conductivity) from first surface 391 to second surface 392.

Within second hybrid area 320b, within first and second semiconductor-on-insulator areas 310a-310b on either side of second hybrid area 320b, and further extending laterally below functional block 399, semiconductor substrate 301 can have multiple well regions. Those skilled in the art will recognize that a well region refers to an area of a semiconductor that is doped with a particular dopant so as to have a particular type of conductivity (e.g., N-type or P-type) at a particular conductivity level. See detailed discussion below regarding dopants that can be employed to achieve a particular type of conductivity depending upon the type of semiconductor material. In any case, these well regions can include, for example, alternating and parallel N-type and P-type well regions (Nwells 304 and Pwells 305) within substrate 301 adjacent to second surface 392. Nwells 304 and Pwells 305 can each extend laterally from functional block 399 across second semiconductor-on-insulator area 320b, second hybrid area 310b, and first semiconductor-on-insulator area 320a toward first hybrid area 320a. These well regions can further include, within first semiconductor-on-insulator area 320a adjacent to first hybrid area 320a, one or more additional Nwells 306 within semiconductor substrate 301. Nwell(s) 306 can be at the second surface 392 and perpendicular to Pwells 305 so as to physically separate and electrically isolate each Pwell 305 from first hybrid area 320a. Finally, these well regions can include a buried N-type well region 303 (buried Nwell) within semiconductor substrate 301 below Nwells 304 and 306 and Pwells 305 and some distance above first surface 391. As mentioned above, semiconductor substrate 301 can be a P-type semiconductor substrate and, thus, buried Nwell 303 can electrically isolate Pwells from a lower portion 302 of semiconductor substrate 301 below.

Within portions A-C of IC structures 300A-300C as illustrated in FIGs. 3.2-3.4, respectively, first semiconductor-on-insulator area 310a separates first hybrid area 320a from second hybrid area 320b. This first semiconductor-on-insulator area 310a can include no more than four gate structures 350 (i.e., less than five gate structures) on the top surface of semiconductor layer 312. Furthermore, this first semiconductor-on-insulator area 310a can be devoid of any dummy field effect transistors (FETs) (also referred to herein as non-functioning FETs). Specifically, gate structures 350 within first semiconductor-on-insulator area 310a can be dummy gate structures (also referred to herein as non-functioning gate structures). A dummy gate structure refers to a gate structure, which either: (a) does not include any gate conductor material(s) or (b) includes gate dielectric and gate conductor materials but is not electrically connected to receive a gate bias voltage. In either case, the dummy gate structure is not able to control the conductivity of the semiconductor material below (i.e., is not able biasable to function as a gate structure for a FET). A dummy FET includes: source/drain regions (i.e., doped regions) within a semiconductor layer and a dummy gate structure on the semiconductor layer between the source/drain regions. Since the dummy gate structure is non-functioning, the FET is effectively non-functioning as well (i.e., a dummy FET).

For purposes of illustration, first semiconductor-on-insulator area 310a is shown in FIGs. 3.2-3.3 as having two gate structures 350 (i.e., two dummy gate structures) on semiconductor layer 312 and further shown in FIG. 3.4 has having a single gate structure 350 (i.e., a single dummy gate structure) on semiconductor layer 312. However, it should be understood that these figures are not intended to be limiting. Alternatively, first semiconductor-on-insulator area 310a in any of these IC structures could include any number of zero to four gate structures 350 (i.e., zero-to-four dummy gate structures). Furthermore, within first semiconductor-on-insulator area 310a, semiconductor layer 312 is devoid of any source/drain regions (i.e., doped regions). Thus, even if first semiconductor-on-insulator region 310a includes dummy gate structure(s) 350, it will not include any dummy FETs.

Additionally, in IC structures 300A-300C and illustrated in portions A-C, respectively, second semiconductor-on-insulator area 310b between second hybrid area 320b and functional block 399 can have at least three gate structures 350 (i.e., three or more gate structures 350) on the top surface of semiconductor layer 312. The gate structures 350 within second semiconductor-on-insulator area 310b can be dummy gate structures. Optionally, one or more of the dummy gate structures within second semiconductor-on-insulator area 310b can be included in a dummy FET 316. That is, second semiconductor-on-insulator area 310b can optionally include source/drain regions 315 within semiconductor layer 312 on opposing sides of one or more of the gate structures 350 and, thus, can include one or more dummy FETs 316.

Within portions A-C of IC structures 300A-300C as illustrated in FIGs. 3.2-3.4, respectively, first hybrid area 320a can include the same first ancillary component. This first ancillary component can also be the same ancillary component as contained in a conventional edge cell. That is, first hybrid area 320a can include a substrate diode 335. This substrate diode 335 can include both an N-type contact region 332 and a P-type contact region 333, which are physically separated from each other and immediately adjacent to P-type semiconductor substrate 301 adjacent second surface 392. It should be understood that P-type contact region 333 can have P-type conductivity at a higher conductivity level than the P-type semiconductor substrate 301. Additionally, it should be understood that contact regions 332-333 can be either doped regions within P-type semiconductor substrate 301 or doped epitaxial semiconductor layers above and immediately adjacent to P-type semiconductor substrate 301. In any case, the junction between N-type contact region 332 and P-type semiconductor substrate 301 effectively forms a diode. Furthermore, N-type contact region 332 can be electrically connected to a positive supply voltage (VDD) rail and P-type contact region 333 (and thereby P-type semiconductor substrate 301) can be electrically connected to a ground (VSS) rail such that substrate diode 335 is reverse biased.

Within portions A-C of IC structures 300A-300C as illustrated in FIGs. 3.2-3.4, respectively, second hybrid area 320b can include a second ancillary component. For example, in IC structure 300A, this second ancillary component can be a zero bias tap component. In IC structure 300B, this second ancillary component can be a bias tap component. In IC structure 300C, this second ancillary component can be a signal antenna component.

More specifically, within portions A-B of IC structures 300A-300B as illustrated in FIGs. 3.2-3.3, respectively, tap components can include an N-type contact region 342 immediately adjacent to an Nwell 304 and a P-type contact region 343 immediately adjacent to a Pwell 305. It should be understood that P-type contact region 343 can have P-type conductivity at a higher conductivity level than Pwell 305 and N-type contact region 342 can have N-type conductivity at a higher conductivity level than Nwell 304. Additionally, it should be understood that contact regions 342-343 can be either doped regions within wells 304-305, respectively, or doped epitaxial semiconductor layers above and immediately adjacent to wells 304-305, respectively. In IC structure 300A as illustrated in FIG. 3.2 where the tap component is a zero bias tap component, contact regions 342-343 can be electrically connected to a ground (VSS) rail. In IC structure 300B as illustrated in FIG. 3.3 where the tap component is a bias tap component, P-type contact region 343 can be electrically connected to receive a Pwell bias voltage (VPW) and N-type contact region 342 can be electrically connected to receive an Nwell bias voltage (VNW). VNW can be different from VPW. Biasing of Pwell 305 and Nwell 304 with VPW and VNW, respectively, can be employed to achieve desired back-gate biasing (e.g., FBB or RBB, as discussed above) of N-type field effect transistors (NFETs) or P-type field effect transistors (PFETs) aligned above the same well regions within functional block 399.

Within portion C of IC structure 300C as illustrated in FIG. 3.4, respectively, a signal antenna component can include back-to-back Pwell diodes 365a-365b. Pwell diode 365a can include a first N-type contact region 362a, which is immediately adjacent to Pwell 305 and which is electrically connected to a ground (VSS) rail. Pwell diode 365b can include a second N-type contact region 362b, which is immediately adjacent to Pwell 305, physically separated and electrically isolated from first N-type contact region 362b and electrically connected to an input pin. It should be understood that N-type contact regions 362a-362b can be either doped regions within P-type semiconductor substrate 301 or doped epitaxial semiconductor layers above and immediately adjacent to P-type semiconductor substrate 301. Furthermore, these N-type contact regions 362a-362b can have a relatively high N-type conductivity (e.g., a higher N-type conductivity than Nwell 304). In any case, the junctions between N-type contact regions 362a and 362b and Pwell 305 effectively form diodes 365a and 365b, respectively. Furthermore, since first N-type contact region 362a is connected to VSS, the Pwell diode 365a is forward biased (i.e., a forward biased Pwell diode). However, since second N-type contact region 362b is connected to an input pin, Pwell diode 365b is reversed biased (i.e., a reverse biased Pwell diode).

Portion D of IC structure 300D as illustrated in FIG. 3.5 can include yet another hybrid area 320c. Within hybrid area 320c, semiconductor substrate 301 can be devoid of any well regions. That is, within hybrid area 320c, semiconductor substrate 301 can be doped only so as to have P-type conductivity at a relatively low conductivity level (e.g., so as to have P-conductivity) from first surface 391 to second surface 392. The stand-alone signal antenna component of CAC cell 224 can include a substrate diode 385 within hybrid area 320c. Substrate diode 385 can include an N-type contact region 382, which is immediately adjacent to P-type semiconductor substrate 301 adjacent second surface 392. Substrate diode 385 can also include a P-type contact region 383, which similarly is immediately adjacent to P-type semiconductor substrate 301 adjacent second surface 392. It should be understood that P-type contact region 383 can have P-type conductivity at a higher conductivity level than the P-type semiconductor substrate and N-type contact region 382 can have N-type conductivity at a higher conductivity level than Nwells within other areas of the semiconductor substrate 301. Additionally, it should be understood that contact regions 382-383 can be either doped regions within semiconductor substrate 301, respectively, or doped epitaxial semiconductor layers above and immediately adjacent second surface 392. In any case, the junction between N-type contact region 382 and P-type semiconductor substrate 301 effectively forms a diode 385. The N-type contact region 382 can be electrically connected to an input pin and the P-type contact region 383 can be electrically connected to a ground (VSS) rail such that the diode 385 is reverse biased.

It should be understood that in the structures described above, a semiconductor material refers to a material whose conducting properties can be altered by doping with an impurity. Exemplary semiconductor materials include, for example, silicon-based semiconductor materials (e.g., silicon, silicon germanium, silicon germanium carbide, silicon carbide, etc.) and III-V compound semiconductors (i.e., compounds obtained by combining group III elements, such as aluminum (Al), gallium (Ga), or indium (In), with group V elements, such as nitrogen (N), phosphorous (P), arsenic (As) or antimony (Sb)) (e.g., GaN, InP, GaAs, or GaP). A pure semiconductor material and, more particularly, a semiconductor material that is not doped with an impurity for the purposes of increasing conductivity (i.e., an undoped semiconductor material) is referred to in the art as an intrinsic semiconductor. A semiconductor material that is doped with an impurity for the purposes of increasing conductivity (i.e., a doped semiconductor material) is referred to in the art as an extrinsic semiconductor and will be more conductive than an intrinsic semiconductor made of the same base material. That is, extrinsic silicon will be more conductive than intrinsic silicon; extrinsic silicon germanium will be more conductive than intrinsic silicon germanium; and so on. Furthermore, it should be understood that different impurities (i.e., different dopants) can be used to achieve different conductivity types (e.g., P-type conductivity and N-type conductivity) and that the dopants may vary depending upon the different semiconductor materials used. For example, a silicon-based semiconductor material (e.g., silicon, silicon germanium, etc.) is typically doped with a Group III dopant, such as boron (B) or indium (In), to achieve P-type conductivity, whereas a silicon-based semiconductor material is typically doped with a Group V dopant, such as arsenic (As), phosphorous (P) or antimony (Sb), to achieve N-type conductivity. A gallium nitride (GaN)-based semiconductor material is typically doped with magnesium (Mg) to achieve P-type conductivity and with silicon (Si) or oxygen to achieve N-type conductivity. Those skilled in the art will also recognize that different conductivity levels will depend upon the relative concentration levels of the dopant(s) in a given semiconductor region.

Methods for forming IC structures with both hybrid and semiconductor-on-insulator areas (and various features therein, such as well regions, contact regions, isolation regions, active and passive semiconductor devices, dummy structures, etc.) using an advanced semiconductor-on-insulator processing technology are well known in the art. Thus, the specific process steps for forming IC structures 300A-300D have been omitted from the specification and figures in order to allow the reader to focus on the salient aspects of the disclosed embodiments (e.g., related to development of design layouts for IC structures through various design flow processes including, but not limited to, selection and placement of one or more instances of any of the CAC cells 221-224 disclosed herein and included in cell library 212 of PDK 210).

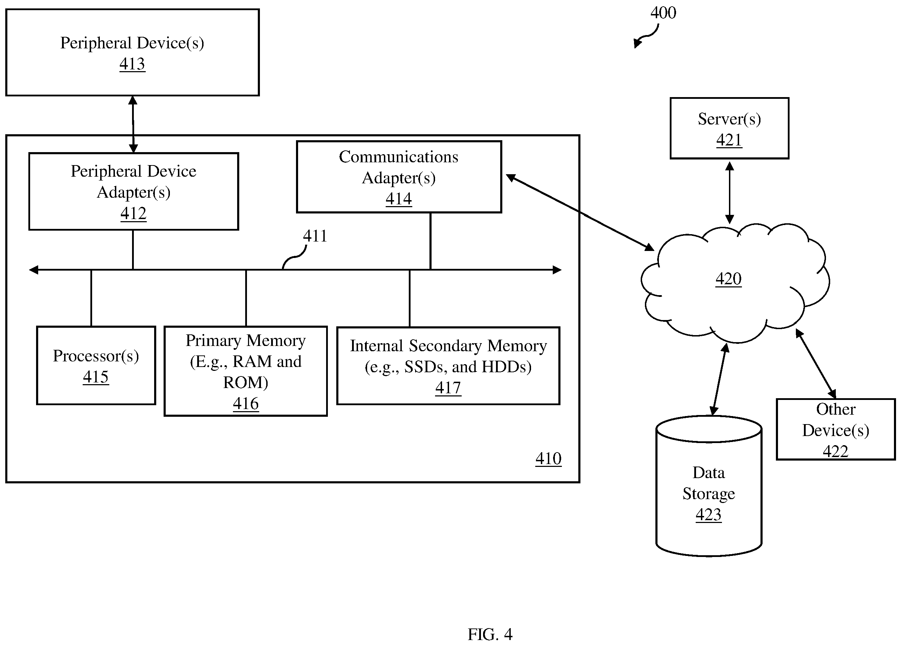

An illustrative hardware environment 400 for implementing aspects of the disclosed systems, methods and computer program products is depicted in FIG. 4. Generally, the hardware environment can include at least one computing device 410 (also referred to herein as a computer). The computer 410 can be, for example, a desktop, laptop, tablet, mobile computing device, etc. The computer 410 can include at least one bus 411. The bus 411 can be connected to various other components of the computer 410 and can be configured to facilitate communication between those components.

The computer 410 can include various adapters. The adapters can include one or more peripheral device adapters 412, which are configured to facilitate communications between one or more peripheral devices 413, respectively, and the bus 411. The peripheral devices 413 can include user input devices configured to receive user inputs. User input devices can include, but are not limited to, a keyboard, a mouse, a microphone, a touchpad, a touchscreen, a stylus, bio-sensor, a scanner, or any other type of user input device. The peripheral devices 413 can also include additional input devices, such as external secondary memory devices (as discussed in greater detail below). The peripheral devices 413 can also include output devices. The output devices can include, but are not limited to, a printer, a monitor, a speaker, or any other type of computer output device. The adapters can include one or more communications adapters 414 (also referred to herein as a computer network adapters), which are configured to facilitate communications between the computer 410 and one or more communications networks 420 (e.g., a wide area network (WAN), a local area network (LAN), the internet, a cellular network, a Wi-Fi network, etc.). Such communications network(s) 420 can, in turn, facilitate communications between the computer 410 and other system components on the communications network: remote server(s) 421, other device(s) 422 (e.g., computers, laptops, tablets, mobile phones, etc.), remote data storage 423, etc.

The computer 410 can further include at least one processor 415 (also referred to herein as a central processing units (CPU)). Optionally, each CPU 415 can include a CPU cache. Each CPU 415 can be configured to read and execute program instructions.

The computer 410 can further include memory and, particularly, non-transistor computer-readable storage mediums. The memory can include primary memory 416 and secondary memory. The primary memory 416 can include, but is not limited to, random access memory (RAM) (e.g., volatile memory employed during execution of program operations) and read only memory (ROM) (e.g., non-volatile memory employed during start-up). The RAM can include, but is not limited to, dynamic random access memory (DRAM), static random access memory (SRAM), or any other suitable type of RAM. The ROM can include, but is not limited to, erasable programmable read only memory (EPROM), flash memory, electronically erasable programmable read only memory (EEPROM), programmable read only memory (PROM), or any other suitable type of ROM. The secondary memory can be non-volatile. The secondary memory can include internal secondary memory 417, such as internal solid state drive(s) (SSD(s)) and/or internal hard disk drive(s) (HDD(s), installed within the computer 410 and connected to the bus 411. The secondary memory can also include external secondary memory connected to or otherwise in communication with the computer 410 (e.g., peripheral devices). The external secondary memory can include, for example, external/portable SSD(s), external/portable HDD(s), flash drive(s), thumb drives, compact disc(s) (CD(s)), digital video disc(s) (DVD(s)), network-attached storage (NAS), storage area network (SAN), or any other suitable non-transitory computer-readable storage media connected to or otherwise in communication with the computer 410. The different functions of primary and secondary memory are well known in the art and, thus, the details thereof have been omitted from this specification in order to allow the reader to focus on the salient aspects of the disclosed embodiments.

In some embodiments, program instructions for performing the disclosed method or a portion thereof, as described above, can be embodied in (e.g., stored in) secondary memory accessible by the computer 410. When the program instructions are to be executed (e.g., in response to user inputs), required information (e.g., the program instructions and other data) can be loaded into the primary memory (e.g., stored in RAM). The CPU 415 can read the program instructions and other data from the RAM and can execute the program instructions. In other embodiments, a client-server model can be employed. In this case, the computer 410 can be a client and a remote server 421 in communication with the computer 410 over a network 420 can provide, to the client, a service including execution of program instructions for performing the disclosed method or a portion thereof, as described above, in response to user inputs the computer 410.

It should be understood that the terminology used herein is for the purpose of describing the disclosed structures and methods and is not intended to be limiting. For example, as used herein, the singular forms "a," "an," and "the" are intended to include the plural forms as well, unless the context clearly indicates otherwise. Additionally, as used herein, the terms "comprises," "comprising," "includes," and/or "including" specify the presence of stated features, integers, steps, operations, elements, and/or components, but do not preclude the presence or addition of one or more other features, integers, steps, operations, elements, components, and/or groups thereof. Furthermore, as used herein, terms such as "right," "left," "vertical," "horizontal," "top," "bottom," "upper," "lower," "under," "below," "underlying," "over," "overlying," "parallel," "perpendicular," etc., are intended to describe relative locations as they are oriented and illustrated in the drawings (unless otherwise indicated) and terms such as "touching," "in direct contact," "abutting," "directly adjacent to," "immediately adjacent to," etc., are intended to indicate that at least one element physically contacts another element (without other elements separating the described elements). The term "laterally" is used herein to describe the relative locations of elements and, more particularly, to indicate that an element is positioned to the side of another element as opposed to above or below the other element, as those elements are oriented and illustrated in the drawings. For example, an element that is positioned laterally adjacent to another element will be beside the other element, an element that is positioned laterally immediately adjacent to another element will be directly beside the other element, and an element that laterally surrounds another element will be adjacent to and border the outer sidewalls of the other element. The corresponding structures, materials, acts, and equivalents of all means or step plus function elements in the claims below are intended to include any structure, material, or act for performing the function in combination with other claimed elements as specifically claimed.

The method as described above is used in the fabrication of integrated circuit chips. The resulting integrated circuit chips can be distributed by the fabricator in raw wafer form (that is, as a single wafer that has multiple unpackaged chips), as a bare die, or in a packaged form. In the latter case the chip is mounted in a single chip package (such as a plastic carrier, with leads that are affixed to a motherboard or other higher level carrier) or in a multichip package (such as a ceramic carrier that has either or both surface interconnections or buried interconnections). In any case the chip is then integrated with other chips, discrete circuit elements, and/or other signal processing devices as part of either (a) an intermediate product, such as a motherboard, or (b) an end product. The end product can be any product that includes integrated circuit chips, ranging from toys and other low-end applications to advanced computer products having a display, a keyboard or other input device, and a central processor.

The descriptions of the various disclosed embodiments have been presented for purposes of illustration but are not intended to be exhaustive or limiting. Many modifications and variations will be apparent to those of ordinary skill in the art without departing from the scope and spirit of the disclosed embodiments. The terminology used herein was chosen to best explain the principles of the embodiments, the practical application or technical improvement over technologies found in the marketplace, or to enable others of ordinary skill in the art to understand the embodiments disclosed herein.

In summary, a system for developing a design in an advanced semiconductor-on-insulator processing technology including a process design kit (PDK) is disclosed. A cell library in the PDK includes compact ancillary component cells placeable adjacent a functional block in a design layout. Some cells contain pairs of ancillary components including: a first ancillary component (e.g., a substrate diode) in a first hybrid area; a second ancillary component (e.g., a zero bias tap, a bias tap, or a signal antenna) in a second hybrid area; a first semiconductor-on-insulator area between the first and second hybrid areas and including less than five gate structures; and a second semiconductor-on-insulator area between the second hybrid area and functional block. Another cell contains a stand-alone signal antenna component and is placeable in the design layout between sections of a stacked memory-type functional block without requiring supporting cells. An IC structure can be manufactured according to such a design layout.
The following embodiments are explicitly disclosed.

### Embodiment 1:

A structure comprising:
a functional block on a semiconductor substrate, wherein the semiconductor substrate includes hybrid areas and semiconductor-on-insulator areas; and
pairs of ancillary components for the functional block,
   wherein the pairs of ancillary components are positioned laterally adjacent to at least one side of the functional block, and
   wherein each pair of ancillary components includes:
      a first ancillary component in a first hybrid area;
      a second ancillary component in a second hybrid area; and
      a first semiconductor-on-insulator area between the first hybrid area and the second hybrid area and including less than five gate structures.

### Embodiment 2:

The structure of embodiment 1,
wherein each pair of ancillary components further includes a second semiconductor-on-insulator area,
wherein the second hybrid area is positioned laterally between the first semiconductor-on-insulator area and the second semiconductor-on-insulator area, and
wherein the second semiconductor-on-insulator area includes at least three gate structures.

### Embodiment 3:

The structure of embodiment 1 or 2,
wherein the semiconductor substrate is a P-type semiconductor substrate,
wherein the first hybrid area is devoid of well regions, and
wherein the first ancillary component includes a substrate diode including an N-type contact region immediately adjacent to the P-type semiconductor substrate.

### Embodiment 4:

The structure of embodiment 3, wherein the substrate diode is reverse biased.

### Embodiment 5:

The structure of embodiment 4,
wherein the N-type contact region of the substrate diode is connected to a positive supply voltage rail, and
wherein first ancillary component further includes a P-type contact region immediately adjacent to the P-type semiconductor substrate and further connected to a ground rail.

### Embodiment 6:

The structure of one of embodiments 1 to 5,
wherein the semiconductor substrate is a P-type semiconductor substrate having a first surface and a second surface opposite the first surface,
wherein the second hybrid area includes, within the P-type semiconductor substrate: a P-type well (Pwell) adjacent the second surface; an N-type well (Nwell) adjacent the second surface and positioned laterally adjacent and parallel to the Pwell; and a buried Nwell below the Pwell and the Nwell and further above and physically separated from the first surface, and
wherein the second ancillary component includes well contact regions including: a **P-**type contact region immediately adjacent the Pwell and an N-type contact region immediately adjacent the Nwell.

### Embodiment 7:

The structure of embodiment 6, wherein the well contact regions are connected to a ground rail.

### Embodiment 8:

The structure of embodiment 6 or 7, wherein the P-type contact region is connected to receive a Pwell bias voltage and the N-type contact region is connected to receive an Nwell bias voltage different from the Pwell bias voltage.

### Embodiment 9:

The structure of one of embodiments 1 to 8,
wherein the semiconductor substrate is a P-type semiconductor substrate having a first surface and a second surface opposite the first surface,
wherein the second hybrid area includes, within the P-type semiconductor substrate: a P-type well (Pwell) adjacent the second surface; an N-type well (Nwell) adjacent the second surface and positioned laterally adjacent and parallel to the Pwell; and a buried Nwell below the Pwell and the Nwell and further above and physically separated from the first surface, and
wherein the second ancillary component includes a forward biased Pwell diode and a reverse biased Pwell diode.

### Embodiment 10:

The structure of embodiment 9, wherein the forward biased Pwell diode includes a first N-type contact region immediately adjacent to the Pwell and connected to a ground rail and wherein the reverse biased Pwell diode includes a second N-type contact region immediately adjacent to the Pwell, physically separated from the first N-type contact region, and connected to an input pin.

### Embodiment 11:

The structure of one of embodiments 1 to 10, wherein the functional block includes any of a memory block and a logic block.

### Embodiment 12:

A structure comprising:
a memory including multiple sections on a semiconductor substrate, wherein the semiconductor substrate is a P-type semiconductor substrate and includes hybrid areas and semiconductor-on-insulator areas; and
a signal antenna component between two of the multiple sections, wherein the signal antenna component is within a hybrid area devoid of well regions and includes: a substrate diode including: an N-type contact region immediately adjacent to the P-type semiconductor substrate and connected to an input pin; and a P-type contact region immediately adjacent to the P-type semiconductor substrate and connected to a ground rail.

In some special illustrative examples of embodiment 12, the structure of embodiment 12 may be related to the structure of one of embodiments 1 to 11 in providing a memory structure in accordance with embodiment 12a or 12b as per the following:

### Embodiment 12a:

The structure of one of embodiments 1 to 11,
wherein the semiconductor substrate is a P-type semiconductor substrate,
wherein the functional block includes multiple sections and a signal antenna component between two of the multiple sections,
wherein the signal antenna component is within an additional hybrid area devoid of well regions and includes: a substrate diode including: an N-type contact region immediately adjacent to the P-type semiconductor substrate and connected to an input pin; and a P-type contact region immediately adjacent to the P-type semiconductor substrate and connected to a ground rail.

### Embodiment 12b:

A memory structure, comprising:
the structure of one of embodiments 1 to 11, and
a memory including multiple sections on the semiconductor substrate, wherein the semiconductor substrate is a P-type semiconductor substrate
wherein the first ancillary component is a signal antenna component between two of the multiple sections, wherein the signal antenna component is within the first hybrid area, the first hybrid area being devoid of well regions and including: a substrate diode including: an N-type contact region immediately adjacent to the P-type semiconductor substrate and connected to an input pin; and a P-type contact region immediately adjacent to the P-type semiconductor substrate and connected to a ground rail.

In some illustrative examples of embodiments 12 and 12a, the structure may be directed to an ancillary component corresponding to ancillary component 224 of FIG. 3.1D (further illustrated in FIG. 3.5), item 224 being located between two sections a and b or b and c of the functional block. Herein, it may be considered as not representing the first ancillary component of the pair of ancillary components when referring to embodiment 11.

### Embodiment 13:

A system, comprising:
a processor; and
a storage medium readable by the processor,
   wherein the storage medium stores a cell library including cells selectable for inclusion in an integrated circuit layout,
   wherein the cells include ancillary component cells for functional blocks,
   wherein at least some of the ancillary component cells are placeable adjacent at least one side of a functional block on a semiconductor substrate and include pairs of ancillary components, and
   wherein each pair of ancillary components include:
      a first ancillary component in a first hybrid area of the semiconductor substrate;
      a second ancillary component in a second hybrid area of the semiconductor substrate; and
      a first semiconductor-on-insulator area between the first hybrid area and the second hybrid area and including less than five gate structures.

In some special illustrative examples of embodiment 13, the system of embodiment 13 may be related to the structure of one of embodiments 1 to 11 in providing a system in accordance with embodiment 13a as per the following:

### Embodiment 13a:

A system comprising:
a processor; and
a storage medium readable by the processor,
   wherein the storage medium stores a cell library including cells selectable for inclusion in an integrated circuit layout comprising the structure of one of embodiments 1 to 11,
   wherein the cells include ancillary component cells for functional blocks,
   wherein at least some of the ancillary component cells are placeable adjacent at least one side of the functional block on the semiconductor substrate and include pairs of ancillary components.

### Embodiment 14:

The system of embodiment 13 or 13a,
wherein each pair of ancillary components further includes a second semiconductor-on-insulator area,
wherein the second hybrid area is positioned laterally between the first semiconductor-on-insulator area and the second semiconductor-on-insulator area, and
wherein the second semiconductor-on-insulator area includes at least three gate structures.

### Embodiment 15:

The system of embodiment 13, 13a or 14,
wherein the semiconductor substrate is a P-type semiconductor substrate,
wherein the first hybrid area is devoid of well regions, and
wherein the first ancillary component includes:
   a substrate diode including an N-type contact region immediately adjacent to the P-type semiconductor substrate and connected to a positive supply voltage rail, and
   a P-type contact region immediately adjacent to the P-type semiconductor substrate and connected to a ground rail such that the substrate diode is reverse biased.

### Embodiment 16:

The system of embodiment 13, 13a, 14 or 15
wherein the semiconductor substrate is a P-type semiconductor substrate having a first surface and a second surface opposite the first surface,
wherein the second hybrid area includes, within the P-type semiconductor substrate: a P-type well (Pwell) adjacent the second surface; an N-type well (Nwell) adjacent the second surface and positioned laterally adjacent and parallel to the Pwell; and a buried Nwell below the Pwell and the Nwell and further above and physically separated from the first surface, and
wherein the second ancillary component includes well contact regions including: a **P-**type contact region immediately adjacent the Pwell and an N-type contact region immediately adjacent the Nwell.

### Embodiment 17:

The system of embodiment 16, wherein the well contact regions are connected to a ground rail.

### Embodiment 18:

The system of embodiment 16 or 17, wherein the P-type contact region is connected to receive a Pwell bias voltage and the N-type contact region is connected to receive an Nwell bias voltage different from the Pwell bias voltage.

### Embodiment 19:

The system of embodiment 13, 13a, 14, 15, 16, 17 or 18,
wherein the semiconductor substrate is a P-type semiconductor substrate having a first surface and a second surface opposite the first surface,
wherein the second hybrid area includes, within the P-type semiconductor substrate: a P-type well (Pwell) adjacent the second surface; an N-type well (Nwell) adjacent the second surface and positioned laterally adjacent and parallel to the Pwell; and a buried Nwell below the Pwell and the Nwell and further above and physically separated from the first surface, and
wherein the second ancillary component includes:
   a forward biased Pwell diode including a first N-type contact region immediately adjacent to the Pwell and connected to a ground rail; and
   a reverse biased Pwell diode including a second N-type contact region immediately adjacent to the Pwell, physically separated from the first N-type contact region, and connected to an input pin.

### Embodiment 20:

The system of embodiment 13, 13a, 14, 15, 16, 17, 18, or 19,
wherein the semiconductor substrate is a P-type semiconductor substrate,
wherein the cells further include signal antenna cells placeable between multiple sections of a memory,
wherein each signal antenna cell includes a signal antenna within an additional hybrid area devoid of well regions, and
wherein the signal antenna includes a substrate diode including:
   an N-type contact region immediately adjacent to the P-type semiconductor substrate and connected to an input pin; and
   a P-type contact region immediately adjacent to the P-type semiconductor substrate and connected to a ground rail.

## Claims

1. A structure comprising:
a functional block on a semiconductor substrate, wherein the semiconductor substrate includes hybrid areas and semiconductor-on-insulator areas, the functional block preferably including any of a memory block and a logic block.; and
pairs of ancillary components for the functional block,
wherein the pairs of ancillary components are positioned laterally adjacent to at least one side of the functional block, and
wherein each pair of ancillary components includes:
a first ancillary component in a first hybrid area;
a second ancillary component in a second hybrid area; and
a first semiconductor-on-insulator area between the first hybrid area and the second hybrid area and including less than five gate structures.

2. The structure of claim 1,
wherein each pair of ancillary components further includes a second semiconductor-on-insulator area,
wherein the second hybrid area is positioned laterally between the first semiconductor-on-insulator area and the second semiconductor-on-insulator area, and
wherein the second semiconductor-on-insulator area includes at least three gate structures.

3. The structure of claim 1 or 2,
wherein the semiconductor substrate is a P-type semiconductor substrate,
wherein the first hybrid area is devoid of well regions, and
wherein the first ancillary component includes a substrate diode including an N-type contact region immediately adjacent to the P-type semiconductor substrate.

4. The structure of claim 3, wherein the substrate diode is reverse biased.

5. The structure of claim 4,
wherein the N-type contact region of the substrate diode is connected to a positive supply voltage rail, and
wherein first ancillary component further includes a P-type contact region immediately adjacent to the P-type semiconductor substrate and further connected to a ground rail.

6. The structure of one of claims 1 to 5,
wherein the semiconductor substrate is a P-type semiconductor substrate having a first surface and a second surface opposite the first surface,
wherein the second hybrid area includes, within the P-type semiconductor substrate: a P-type well (Pwell) adjacent the second surface; an N-type well (Nwell) adjacent the second surface and positioned laterally adjacent and parallel to the Pwell; and a buried Nwell below the Pwell and the Nwell and further above and physically separated from the first surface, and
wherein the second ancillary component includes well contact regions including: a **P-**type contact region immediately adjacent the Pwell and an N-type contact region immediately adjacent the Nwell,
wherein the well contact regions are preferably connected to a ground rail, and/or
wherein the P-type contact region is preferably connected to receive a Pwell bias voltage and the N-type contact region is preferably connected to receive an Nwell bias voltage different from the Pwell bias voltage.

7. The structure of one of claims 1 to 6,
wherein the semiconductor substrate is a P-type semiconductor substrate having a first surface and a second surface opposite the first surface,
wherein the second hybrid area includes, within the P-type semiconductor substrate: a P-type well (Pwell) adjacent the second surface; an N-type well (Nwell) adjacent the second surface and positioned laterally adjacent and parallel to the Pwell; and a buried Nwell below the Pwell and the Nwell and further above and physically separated from the first surface, and
wherein the second ancillary component includes a forward biased Pwell diode and a reverse biased Pwell diode,
wherein the forward biased Pwell diode preferably includes a first N-type contact region immediately adjacent to the Pwell and connected to a ground rail and wherein the reverse biased Pwell diode preferably includes a second N-type contact region immediately adjacent to the Pwell, physically separated from the first N-type contact region, and connected to an input pin.

8. The structure of one of claims 1 to 7,
wherein the semiconductor substrate is a P-type semiconductor substrate,
wherein the functional block includes multiple sections and a signal antenna component between two of the multiple sections,
wherein the signal antenna component is within an additional hybrid area devoid of well regions and includes: a substrate diode including: an N-type contact region immediately adjacent to the P-type semiconductor substrate and connected to an input pin; and a P-type contact region immediately adjacent to the P-type semiconductor substrate and connected to a ground rail.

9. A system comprising:
a processor; and
a storage medium readable by the processor,
wherein the storage medium stores a cell library including cells selectable for inclusion in an integrated circuit layout comprising the structure of one of claims 1 to 8,
wherein the cells include ancillary component cells for functional blocks,
wherein at least some of the ancillary component cells are placeable adjacent at least one side of a functional block on a semiconductor substrate and include pairs of ancillary components.

10. The system of claim 9,
wherein each pair of ancillary components further includes a second semiconductor-on-insulator area,
wherein the second hybrid area is positioned laterally between the first semiconductor-on-insulator area and the second semiconductor-on-insulator area, and
wherein the second semiconductor-on-insulator area includes at least three gate structures.

11. The system of claim 9 or 10,
wherein the semiconductor substrate is a P-type semiconductor substrate,
wherein the first hybrid area is devoid of well regions, and
wherein the first ancillary component includes:
a substrate diode including an N-type contact region immediately adjacent to the P-type semiconductor substrate and connected to a positive supply voltage rail, and
a P-type contact region immediately adjacent to the P-type semiconductor substrate and connected to a ground rail such that the substrate diode is reverse biased.

12. The system of one of claims 9 to 11,
wherein the semiconductor substrate is a P-type semiconductor substrate having a first surface and a second surface opposite the first surface,
wherein the second hybrid area includes, within the P-type semiconductor substrate: a P-type well (Pwell) adjacent the second surface; an N-type well (Nwell) adjacent the second surface and positioned laterally adjacent and parallel to the Pwell; and a buried Nwell below the Pwell and the Nwell and further above and physically separated from the first surface, and
wherein the second ancillary component includes well contact regions including: a **P-**type contact region immediately adjacent the Pwell and an N-type contact region immediately adjacent the Nwell.

13. The system of claim 12, wherein the well contact regions are connected to a ground rail, and/or
wherein the P-type contact region is connected to receive a Pwell bias voltage and the N-type contact region is connected to receive an Nwell bias voltage different from the Pwell bias voltage.

14. The system of one of claims 9 to 13,
wherein the semiconductor substrate is a P-type semiconductor substrate having a first surface and a second surface opposite the first surface,
wherein the second hybrid area includes, within the P-type semiconductor substrate: a P-type well (Pwell) adjacent the second surface; an N-type well (Nwell) adjacent the second surface and positioned laterally adjacent and parallel to the Pwell; and a buried Nwell below the Pwell and the Nwell and further above and physically separated from the first surface, and
wherein the second ancillary component includes:
a forward biased Pwell diode including a first N-type contact region immediately adjacent to the Pwell and connected to a ground rail; and
a reverse biased Pwell diode including a second N-type contact region immediately adjacent to the Pwell, physically separated from the first N-type contact region, and connected to an input pin.

15. The system of one of claims 9 to 14,
wherein the semiconductor substrate is a P-type semiconductor substrate,
wherein the cells further include signal antenna cells placeable between multiple sections of a memory,
wherein each signal antenna cell includes a signal antenna within an additional hybrid area devoid of well regions, and
wherein the signal antenna includes a substrate diode including:
an N-type contact region immediately adjacent to the P-type semiconductor substrate and connected to an input pin; and
a P-type contact region immediately adjacent to the P-type semiconductor substrate and connected to a ground rail.
